Europäisches Patentamt

European Patent Office

Office européen des brevets

(11) Publication number: 0 371 771
A2

# EUROPEAN PATENT APPLICATION

(21) Application number: 89312384.4

(22) Date of filing: 29.11.89

(51) Int. Cl.5: C01B 21/072, C04B 35/58,
C30B 11/00, C30B 29/40,
C30B 29/60

(30) Priority: 29.11.88 US 277248
08.11.89 US 433516

(43) Date of publication of application:
06.06.90 Bulletin 90/23

(84) Designated Contracting States:
BE DE FR GB IT NL SE

(71) Applicant: ALCAN INTERNATIONAL LIMITED
1188 Sherbrooke Street West
Montreal Quebec H3A 3G2(CA)

(72) Inventor: Poste, Steven Douglas
31 Hillendale Avenue
Kingston Ontario K7M 1S2(CA)
Inventor: Raghavan, Narasimha Srinivasa
24 Glenaire Mews
Kingston Ontario K7M 7L3(CA)

(74) Representative: Wilkinson, Stephen John et al
c/o Stevens, Hewlett & Perkins 5 Quality
Court Chancery Lane
London WC2A 1HZ(GB)

(54) Process for preparing aluminium nitride and aluminium nitride so produced.

(57) A process for preparing aluminum nitride comprises reacting molten aluminum with nitrogen (or a nitrogen precursor) at a pressure of up to about 0.2 MPa (absolute) in the presence of less than about 5% by weight of a dopant selected from the metals magnesium, calcium, strontium and barium. The dopants reduce the passivation of aluminum to the formation of the nitride and impart desirable properties to the resulting aluminum nitride. In the case of magnesium, the nitride can be obtained in the form of novel single crystals of 1-10μm in size. In the case of the other dopants, the resulting aluminum nitride can be sintered without the use of additional sintering aids.

# PROCESS FOR PREPARING ALUMINUM NITRIDE AND ALUMINUM NITRIDE SO PRODUCED

## CROSS-REFERENCE TO RELATED APPLICATION

This application is a continuation-in-part of prior application Serial No. 277,248 filed on November 29, 1988, now abandoned.

## BACKGROUND OF THE INVENTION

### I. FIELD OF THE INVENTION

This invention relates to a process for preparing aluminum nitride and to the aluminum nitride so-produced.

### II. DESCRIPTION OF THE PRIOR ART

Aluminum nitride is attracting much attention nowadays as a material for use in substrates for microelectronic devices, structural materials, metal or ceramic matrix composite materials and for other specialized applications. When aluminum nitride is used for microelectronic devices it has to be in highly pure form and should have good thermal conductivity but low electrical conductivity. When used for structural purposes, e.g. as high impact resistant materials, the purity of the aluminum nitride is less important, but the particles should be readily sinterable and capable of producing a dense product. When used for matrix reinforcement, the particles should preferably be large and consist of single crystals.

Conventionally, aluminum nitride powder is produced in bulk quantities by the carbonitridation of alumina (see, for example, U.S. Patent 2,835,566 granted to R. Perieres et. al. on May 20, 1958). The reaction proceeds at temperatures of about 1750 $^\circ$ C according to the following equation:

$$Al_2O_3(s) + 3C(s) + N_2(g) \rightarrow 2AlN(s) + 3CO(g)$$

If this process is to be used for producing a product of high purity, then high purity starting materials must be used and this significantly increases the cost. Moreover, it is difficult to avoid contamination of the product with unreacted starting materials. The resulting product is in the form of polycrystalline agglomerates which tend not to sinter to high density and may require the use of sintering aids.

If a high purity product is desired, the direct nitridation of aluminum metal is of interest because high purity starting materials are readily and inexpensively available and because there are no byproducts or recycle streams to contend with. The reaction proceeds according to the following equation:

$$Al(1) + 1/2N_2(g) \rightarrow AlN(s)$$

Although the reaction is thermodynamically favourable over a wide temperature range, passivation of the reactants and slow kinetics limit the yield of the reaction product at temperatures below about 1750 $^\circ$ C, and this makes the process difficult and expensive. Attempts have been made to improve the process, e.g. by synthesizing bulk pieces of AlN by striking an arc between two aluminum electrodes contained within a nitrogen atmosphere (G. Long and L.M. Foster, Journal of the American Chemical Society, Vol. 42, Feb. 1, 1959). Attempts have also been made to bring about the direct nitridation of aluminum powder. The use of aluminum powder increases the reaction surface area and decreases the unit reaction volume, hence reducing the impact of the passivation effects. Examples of such methods include the nitriding of aluminum powder in a jet of nitrogen plasma (D.P. Zyatkevich, et. al., Poroshkovaya Metallurgica, No. 10 (178), pp 1-5, October, 1977); the nitriding of mixtures of aluminum powder and lithium fluoride powder (C.F. Cooper et. al., Special Ceramics 4, Proceedings of a Symposium of the British Ceramic Research Association, pp 1-13, 1968); and the nitriding of mixtures of aluminum powder and fluoride salts (British Patent 784,126 to Charlton and Evans, published on October 2, 1957). However, these methods have not been successful on a commercial scale.

In U.S. patent 3,607,046 issued on September 21, 1971 to Charles M. Little, aluminum nitride is formed by bringing together pure aluminum and a small amount of lithium under dry conditions and heating these two metals in the presence of nitrogen at about normal atmospheric pressure. The lithium appears to overcome the normal passivation of the aluminum and so the aluminum nitride may be produced more rapidly. This process nevertheless has severe disadvantages because lithium is toxic and very difficult to handle. It is very reactive, prone to oxidation and presents an explosion hazard if it is likely to contact water.

U.S. patent 3,395,981 which issued on August 6, 1968 to Werner Kischio discloses a similar process employing zinc as an additive for the aluminum in order to overcome the passivation of the aluminum. In this case, however, the amount of the additive metal which has to be employed is between 5 and 20% by weight of the alloy with the aluminum. This results in an aluminum nitride product which contains a large percentage of residual zinc, making the product unsuitable for many applications. Furthermore, the yield of the process is substantially reduced by the large alloy additions.

It has furthermore been disclosed by S. Kudela (Int. Leichtmetalltag, Vol. 7, pp 200-201, 1981) that aluminum nitride may be prepared from aluminum magnesium alloys. This procedure is primarily intended for the production of ceramic-metallic composites although, in a special case, the reaction can be carried to completion for the complete conversion of aluminum to aluminum nitride. According to the Kudela disclosure, rapid bulk reaction, rather than mere surface reaction, takes place at relatively low temperatures (e.g. 1131-1266°C), but only at high nitrogen overpressures (typically 1 to 4 MPa) which make the process difficult to operate on a commercial scale.

Accordingly there is a need for a more suitable process for producing aluminum nitride of suitable purity, particle size and particle shape, etc. and it is an object of this invention to satisfy this need.


## SUMMARY OF THE INVENTION

The present invention is based in part on the finding that aluminum can be made to react rapidly. with nitrogen or a nitrogen precursor (such as ammonia or an amine), both at relatively low temperatures and at low pressures, to form desirable aluminum nitride products, when certain dopants are present during the nitridation reaction.

Thus, according to one aspect of the present invention, there is provided a process for preparing aluminum nitride, which comprises: reacting molten aluminum with a reagent selected from the group consisting of nitrogen and nitrogen precursors, at a pressure of up to about 0.2 MPa (absolute), the reaction being carried out in the presence of less than 5% by weight of a dopant, based on the total weight of the aluminum and the dopant, selected from the group consisting of magnesium, calcium, strontium and barium.

According to another aspect of the present invention, there is provided aluminum nitride in the form of single crystal particles having a size in the range of about 1μm-10μm.

Other aspects of the invention will also be apparent from the following disclosure.

A main advantage of the present invention is that it provides a process which produces aluminum nitride particles in forms that are very desirable for certain specialized uses while enabling the particles to be produced relatively inexpensively in view of the low pressures and relatively low temperatures that can be employed. This is possible because quite small amounts of the selected dopants unexpectedly reduce the passivation of aluminum to nitridation without giving rise to handling and processing problems.


## BRIEF DESCRIPTION OF THE DRAWINGS

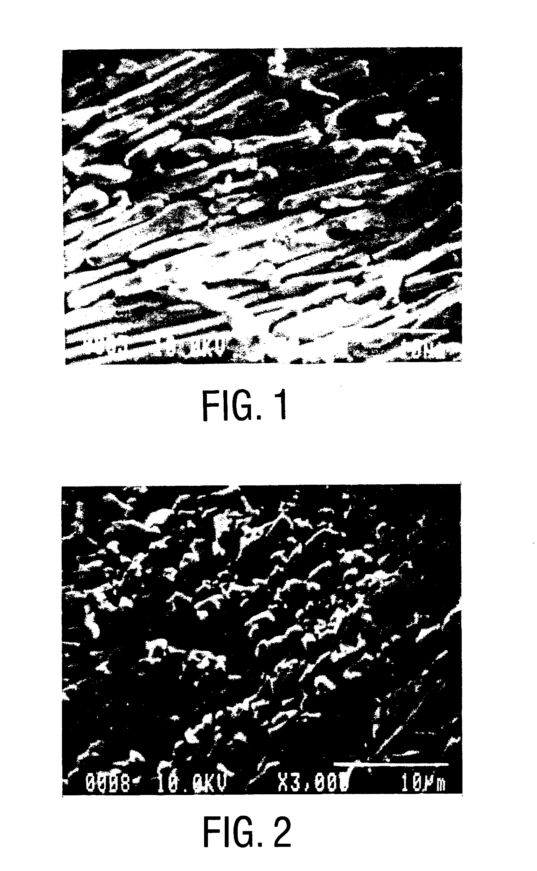

Figs. 1 to 6 are photo micrographs of AlN products produced according to the invention or the prior art as explained in the Examples below.


## DETAILED DESCRIPTION OF THE PRESENT INVENTION AND THE PREFERRED EMBODIMENTS THEREOF


### A. General Process Conditions

As noted above, an important advantage of the present invention is that the nitridation process can be carried out at a low pressure, i.e. a pressure below about 0.2 MPa and preferably at atmospheric pressure (0.1 MPa). Such pressures are considerably below the 1 MPa or more required for bulk nitridation required by Kudela in the article mentioned above. It is therefore possible to carry out the process of the present invention in relatively inexpensive ambient pressure apparatus, which is economically advantageous, especially when the reaction is carried out on a commercial scale.

While it is convenient to use nitrogen at atmospheric pressure, higher pressures (within the stated range) may be required to speed up the reaction rate or to compensate for reduced dopant levels, lower temperatures or high gas train pressure losses. Conversely, lower pressures may be required to slow down the reaction or to compensate for high reaction temperatures. The usual pressure range is from 0.01 to 0.2 MPa (absolute).

If it is desired to use lower nitrogen pressures, the total pressure in the reaction apparatus may be reduced or, alternatively, the partial pressure of the nitrogen may be reduced while the total pressure in the apparatus is maintained at about atmospheric pressure, e.g. by diluting the nitrogen with a non-reactive gas such as argon. Partial pressures as low as 0.005 MPa may be achieved in this way. If the option of reducing the total pressure in the apparatus is chosen, pressures of nitrogen lower than the vapour pressure of the aluminum nitride product phase at the reaction temperature should not be employed. As the reaction proceeds, it may be found that the partial and/or total pressure may decrease if the nitrogen is consumed at a rate faster than it is supplied. For the desired nitridation to take place, the molten aluminum must come into contact with nitrogen at the reaction temperature in the presence of the dopant. This may be achieved by supplying nitrogen gas or a gas mixture (as indicated above) to the reaction apparatus or by supplying a nitrogen precursor which decomposes to nitrogen at the reaction conditions, e.g. ammonia or an amine. Alternatively, the nitrogen may be supplied in the form of a nitrogen plasma containing monatomic nitrogen or nitrogen ions.

The reaction is carried out at a temperature high enough to melt the aluminum or aluminum alloy and to bring about the nitridation reaction to a significant extent when the dopant is present. When the process is carried out on a commercial scale, the lowest effective temperature is normally employed in order to make the process as economical as possible. Temperatures falling within the range of the melting point of the aluminum to the temperature at which the volatilization of the dopant becomes significant are normally suitable. In practice, the reaction temperature normally falls within the range of approximately $550^\circ$ C to $1650^\circ$ C, and preferably within the range of $800^\circ$ C to $1450^\circ$ C.

The dopants used in the present invention are all metals but compounds of these metals may be employed as dopant precursors if the compounds decompose or are reduced to the metal under the nitridation conditions. Preferably, the aluminum and the dopant are alloyed before the nitridation reaction is commenced but the dopant or dopant precursor may alternatively be coated on the surface of the aluminum prior to the reaction, positioned in such a manner that it flows onto the aluminum at the reaction temperature, or the reactant nitrogen gas flowing into the reaction zone may be saturated with the dopant either within or outside of the reaction apparatus. The important consideration is that the dopant must be present at the reactive surface of the aluminum when the nitridation reaction takes place such that an alloy forms at the surface of the aluminum.

Reaction times range from essentially instantaneous to 24 hours. The actual time depends on the process conditions because the temperature, pressure, particular dopant and reactor geometry can all affect the reaction time. In some instances, there is an incubation period before the aluminum reacts to any appreciable extent, whereas in other instances, the aluminum reacts as soon as it reaches the reaction temperature.

The reaction is normally carried out by placing the aluminum and dopant (generally combined as an alloy) in an inert open container capable of resisting the temperatures employed in the reaction, and positioning the container in a furnace capable of being supplied with a nitrogen atmosphere at a predetermined pressure and capable of raising the temperature of the entire body of aluminum controllably to a predetermined value. As the temperature inside the furnace is raised, the metals melt and react with the nitrogen. At the temperatures and pressures employed, essentially all of the aluminum reacts and the nitride product remains in the container and can be collected when sufficiently cooled.

The furnace and the container should be designed to function in controlled pressure nitrogen-containing atmospheres and should preferably not contribute contaminants to the metal or product. However, since the reaction is exothermic, it may not be necessary to use a conventional furnace. For example, the molten aluminum and dopant may be sprayed into a nitrogen atmosphere at the desired temperature through a suitable nozzle. This causes an essentially spontaneous reaction and a solid nitride powder can be collected from the bottom of the reaction enclosure. Atomization of the metal may be brought about by directing a hot jet of nitrogen against a stream of the molten metals or by other methods well known to those skilled in the art as part of the nitridation process.

## B. Dopants and Products

The dopants used in the process of the present invention are the metals magnesium, calcium, strontium and barium. These metals have unexpectedly been found to have advantages over other metal dopants such as lithium and zinc as used, respectively, by Little and Kischio. These advantages are explained in detail below.

Firstly, the elements are all effective in relatively small amounts within the range of about 0.1 to 5% (preferably 0.1 to 3%) by weight based on the total weight of the aluminum and the dopant. This means that the aluminum nitride product is relatively uncontaminated with residual dopant and special additional steps to remove the dopant may not be required, depending on the intended use of the product.

A bulk liquid nitrogen source can be employed if desired for reduced cost. Commercial purity aluminum can also be used as a starting material.

### (i) Magnesium

It has been found unexpectedly that magnesium, when used as a dopant, produces aluminum nitride products that differ from those produced when Ca, Sr and Ba are used as dopants. Moreover, the products produced when Mg is employed can be made to differ according to the reaction conditions.

When Mg is employed, the aluminum nitride product is produced in the form of relatively large single crystals which, although often loosely attached, can be separated by mild comminution. Large single crystals of this type are believed to be novel because conventional products usually consist of agglomerates of strongly adhering submicronic crystals. The shape and size of the single crystals resulting from the use of Mg vary according to the reaction conditions in a way that is not yet fully understood, but it seems that the use of higher reaction temperatures (e.g. about 1200°C) and lower magnesium contents (e.g. about 1% Mg) leads to the formation of equiaxial particles or platelets. On the other hand, the combination of lower magnesium contents with lower temperatures (e.g. about 1000°C) produces acicular crystals (needles) or dendrites. The different particle shapes may have something to do with the fact that higher magnesium contents and higher temperatures lead to faster reaction rates, and slower reactions favour acicular or dendritic particles. It seems, however, that particle shapes are not affected by rates of cooling following the completion of the nitridation reaction.

The acicular particles generally have a size of about $10\mu m \times 1\mu m$; the equiaxial particles generally have a size of about $1-2\mu m$; and platelets generally have a size of about $1-2\mu m \times 4-5\mu m$. Large single crystals of this kind are very useful as reinforcements for metal or ceramic matrices because they have great tensile strength. The platelets, needles and dendrites are especially useful for reinforcement purposes. Single crystals of aluminum nitride in the size range of about $1-10\mu m$ are believed to be novel and form an aspect of this invention.

While the large single crystals do not usually give sintered products which have good thermal conductivity, and so may not be very useful for forming substrates for electronic components, it has been found that this disadvantage can be overcome by mixing the large single crystals with a conventional high purity aluminum nitride product normally used for such purposes. Unexpectedly, the large crystals do not reduce the good thermal conductivity obtainable from the conventional product to the extent that would be expected and products with desirable thermal properties can be obtained by using mixtures containing large proportions of the single crystal product of the invention. For example, the use of 70% by weight of $10\mu m$ particles with 30% by weight of a conventional product was converted to a sintered product having a thermal conductivity of 127 watts/metre/°K compared with 200 watts/metre/°K for the product produced from the conventional material itself and only 4.5 watts/metre/°K for the product produced from the large single crystal material of the invention.

There are two main advantages of making sintered products from mixtures of conventional high thermal conductivity materials and large single crystal material of the invention. Firstly, the conventional material, being highly pure, is very expensive whereas the large single crystal material of the present invention can normally be produced much more cheaply (e.g. for about 10-15% of the cost) and so there is a large economic advantage. Secondly, the large single crystals in the mixture with the smaller conventional particles (normally $1-2\mu m$) make the mixture less likely to shrink during sintering. Thus the resulting sintered product is cheaper and subject to better volume control than the conventional products.

The relative proportions of the conventional material and the large single crystal material of the invention can be varied widely according to the characteristics required of the product and optimum proportions for any particular application can be determined by simple experimentation. It should of course also be noted that sintering aids, such as yttria, conventionally used for the sintering of the conventional aluminum nitride products may also be used for sintering the mixtures described above. The sintering aids are normally required in the conventional amounts.

The concept of using mixtures of aluminum nitride of different particle size to produce desirable sintered products can be extended in the following way. The amount of high purity highly sinterable conventional product required to produce sintered bodies can be reduced without significantly adversely affecting the product characteristics by mixing the conventional product with a proportion of low surface area, large grain size or unreactive aluminum nitride of any kind (i.e. not necessarily that produced by the present invention). This is believed to be because the more reactive aluminum nitride particles, in reducing their surface area at the sintering temperature, help to bond the less sinterable particles together, thereby allowing the entire green body to sinter. Because this allows sintering to take place and removes porosity that would be present in a green body made of one type of particle alone, a highly dense product can be formed.

### (ii) Calcium, Strontium and Barium

The aluminum nitride products produced when Ca, Sr or Ba are used as dopants instead of Mg are rather different. Large single crystals of aluminum nitride are not usually formed and instead dense agglomerates of submicronic crystallites are commonly produced. These agglomerates can be ground to any desired size fraction. The aluminum nitride products resulting from the use of these dopants do, however, have a very distinct and unexpected advantage not observed when other dopants are employed, namely that the products can be sintered to high densities (usually at least 90% theoretical and often at least 95%) without the need for external sintering aids. Furthermore, the sintered products generally have optimal properties for use as electronic substrates, i.e. high thermal conductivity and low electrical conductivity. Without wishing to be limited to any particular theory, this may be because the dopant (or nitride thereof) remaining in the aluminum nitride product acts as a sintering aid and is present in sufficient quantities to scavenge impurities present on the surface of the AlN particles, and to "de-wet" (withdraw from the particle surfaces) during sintering and concentrate in the "triple points" between clusters of three adjacent particles. Here the dopants may act to adhere the particles together without preventing direct contact between the nitride particles at the main points of contact of the particles, which is required for good thermal conductivity.

### C. Beneficiation

When using the dopants mentioned above there is often no contamination of the aluminum nitride product or, if there is, the contamination is desirable, as in the case of the sinterability imparted by the residual Ca, Sr or Ba or nitrides thereof. However, in those cases where there is undesirable contamination, the contaminating materials may be removed by carrying out a beneficiation step after the nitridation step is complete. This normally involves a further heat treatment of the aluminum nitride product in a controlled atmosphere (oxidizing or non-oxidizing) at a suitably high temperature to cause decomposition or volatilization of the contaminant.

The beneficiation step may merely be a continuation of the nitridation step, possibly at reduced pressure and/or higher temperature, or it may be a distinct second step. It is clearly advantageous in most cases to carry out the beneficiation step as a continuation of the nitridation procedure because the nitride product is already heated to a temperature approaching the desired treatment temperature. The time, temperature and pressure employed for the beneficiation depend on the particular dopant employed, the thermal history of the aluminum nitride product and the geometry of the reaction equipment, etc. However, since the procedure is a diffusion controlled reaction, the volatile contaminant will decrease in concentration with decreasing pressure, increasing temperature and decreasing diffusion distance. The use of a flowing gas or gettering atmosphere decreases the partial pressure of the volatile species and helps to drive the volatilization reaction to completion.

The preferred pressure employed for the beneficiation step is in the range of $1.33 \times 10^{-4}$ Pa to 0.2 MPa (absolute), the usual treatment time may be up to 24 hours and the usual temperature is in the range of 550-1650 °C.

Any residual carbon in the product (e.g. carbon originating from the furnace or the container) can be eliminated by low temperature oxidation carried out as a final part of the nitridation or beneficiation step, or as a separate step.

The product obtained by the above procedure is normally either a particulate solid or a coherent body that can easily be crushed to form a particulate solid.

6

## D. Reaction sintering

In the above disclosure, aluminum alloys containing one of the dopant materials is reacted at relatively low temperature and pressure with nitrogen to form aluminum nitride. If finely divided alloys of this type are mixed with aluminum nitride powder, and sintering of the powder is carried out under an atmosphere of nitrogen or a nitrogen precursor, the alloy will be converted to aluminum nitride and will bond together the particles of aluminum nitride from the original mixture and will fill the pores between these particles. This means that sintering can take place at much lower temperatures than is normally the case. Usual sintering temperatures for aluminum nitride are about 1700° C or more and, by employing a doped aluminum alloy in this way, the sintering temperature can be substantially reduced from temperatures in excess of 1700° C to temperatures desirable for the nitridation of the particular alloy, e.g. between about 600 and 1450° C.

If an impure sintered product is acceptable, the doped aluminum alloy can also be used for the reaction sintering of other ceramic materials e.g. alumina. The doped alloy is mixed with the ceramic particles, the mixture is shaped as desired and then heating in a nitrogen atmosphere is carried out a temperature above the melting point of the alloy. The resulting product contains particles of the ceramic sintered together with aluminum nitride.

Useful background information about reaction sintering can be obtained from an article entitled "REACTION-BONDED SILICON NITRIDE: ITS FORMATION AND PROPERTIES" by A.J. Moulson, Journal of Material Science, Vol 14, 1979. The disclosure of this reference is incorporated herein.

The invention is described in further detail with reference to the following Examples which are provided for the purpose of illustration only and should not be viewed as limiting the scope of the present invention.

## Example 1

Ingots of identical composition (99.999% Al alloyed with 3 wt % of Mg) were subject to nitridation reactions under different conditions as explained below.

In each case, the ingot was placed within an open crucible made of high purity $Al_2O_3$ and was heated in a furnace under flowing nitrogen maintained at 0.112-0.115 MPa to the desired treatment temperature.

The furnace was held at the desired treatment temperature either for a predetermined time or until nitrogen flow sensors indicated that the nitridation reaction was complete.

After cooling, the crucibles were removed from the furnace, the weight gains were determined and portions of the samples were submitted to chemical analysis.

The aluminum nitride product which was formed was in all cases coherent but porous and was easily comminuted to a powder. In all but one case, theoretical weight gains (51.9%) were achieved.

The reaction conditions and results for each case are shown in Table 1 below.

TABLE 1

| TEST NO. | 5658-11 | 5658-89 | 5658-94 | 5697-03 | 5794-71 | 5794-71* |
|---|---|---|---|---|---|---|
| TEMP °C | 1200 | 1250 | 1250 | 1200 | 1100 | 1100 |
| TIME H | 16 | 18 | 14 | 16 | 8.6 | 8.6 |
| WT.GAIN | 44.9 | 51.3 | 52.2 | 50.0 | 52.5 | 52.5 |
| XRD.ANAL | -- | AIN | AIN | AIN | AIN TRACE Mg | AIN |
| XRF ANAL % | -- | C 0.2 O 0.8 Si 0.010 Ca<0.001 Fe 0.001 | C 0.1 O 0.6 Si 0.007 Ca<0.001 Fe 0.001 | -- | C 0.5 O 0.7 Si 0.02 Ca 0.003 Fe 0.05 Mg 1.2 S 0.002 Ni 0.01 Co 0.001 Cr 0.01 | C 0.5 O 0.7 Si 0.02 Ca 0.003 Fe 0.04 Mg 0.14 S 0.002 Ni 0.01 Co 0.001 Cr 0.01 |

* This sample was subjected to a post synthesis thermal treatment under vacuum to lower the Mg impurity level, as shown in the Table.

**EXAMPLE 2**

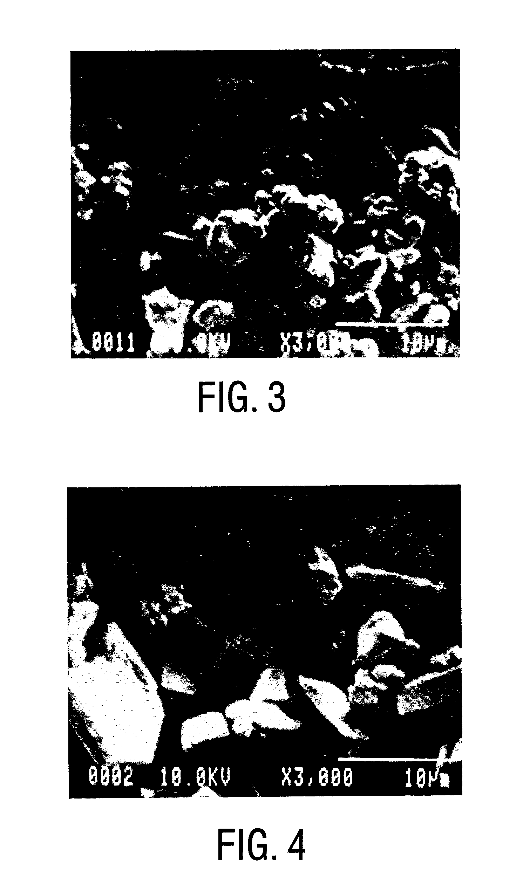

A series of experiments were performed to determin the effects of the magnesium content of the alloy and temperature on the morphology of the AIN product formed by reaction with flowing nitrogen. The AIN sample was synthesized by placing an ingot of nominal composition of either Al-1 wt.% Mg or Al-3 wt.% Mg, weighing approximately 28 g into a high purity 30 mm I.D. alumina crucible and heating the assembly at a rate of 10° C/min in 4 L/min of flowing nitrogen to a target temperature of either 1000° C or 1200° C and holding for a time sufficient for nitridation of the aluminum to occur. The material was then cooled to room temperature, removed from the crucible, fractured, and viewed using a scanning electron microscope. This procedure was repeated for both alloy types and both temperatures. The morphologies of the four samples are shown in Figures 1 to 4. Figure 1 shows the product prepared from Al-1% Mg at 1000° C. Figure 2 shows the product prepared from Al-3% Mg at 1000° C. Figure 3 shows the product prepared from Al-1% Mg at 1200° C. Figure 4 shows the product prepared from Al-3% Mg at 1200° C. The Figures illustrate that the degree of accicularity decreases with increasing temperature and/or Mg content of the alloy.

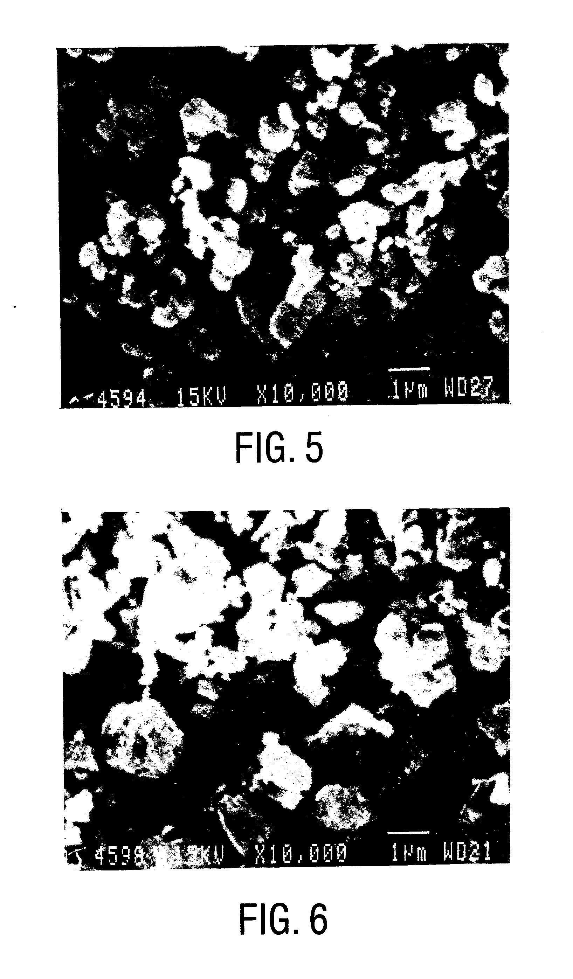

Figures 5 and 6 show commercially available AIN powders synthesized by the two main processes used for the commercial production of AIN powder, the carbo-nitridation of alumina and the nitridation of aluminum powder, respectively. These AIN powders are essentially spherical in nature and are of a very small size (approximately 1 μm) which is typical for commercial high purity AIN powder. The powder produced by the process detailed in this Example is unique with respect to both shape and size, and furthermore the morphology of the particulates can be controlled by the proper choice of processing conditions.

**EXAMPLE 3**

A series of experiments were performed to determine the effects of reaction temperature on the time required for nitridation for AIN synthesis from an Al-2 wt.% Ca alloy in a flowing nitrogen atmosphere. The AIN was synthesized by placing an ingot of Al-2 wt.% Ca alloy weighing approximately 20 g into a high purity 30 mm I.D. alumina crucible and heating the assembly at a rate of 10° C/min in 4 L/min of flowing nitrogen to a target temperature of either 900, 1000, and 1100° C and holding for a time sufficient for nitridation of the aluminum to occur. Throughout the experiment the flow of nitrogen entering and exiting the furnace was measured, and the nitrogen consumption monitored. The material was then cooled to room temperature and the weight gain was determined.

The results displayed in Table 2 indicate that the time required for complete reaction decreases with increasing temperature for the process conditions studied.

TABLE 2

| TEMPERATURE | REACTION COMPLETION TIME | % Wt. GAIN |
|---|---|---|
| (°C) | (h) | (Al Basis) |
| 900 | 4.5 | 51.0 |
| 1000 | 2.0 | 51.0 |
| 1100 | 1.7 | 51.0 |

**EXAMPLE 4**

The formation of AlN from an Al-Ba alloy has also been demonstrated. The AlN was synthesized by placing a ingot of Al-1.7 wt.% Ba alloy weighing approximately 20 g into a high purity 30 mm I.D. alumina crucible and heating the assembly at a rate of 10°C/min in 4 L/min of flowing nitrogen to a target temperature of 1100°C and holding for a time sufficient for nitridation of the aluminum to occur. Throughout the experiment the flow of nitrogen entering and exiting the furnace was measured, and the nitrogen consumption monitored. The material was then cooled to room temperature and the weight gain was determined. The results are displayed in Table 3.

TABLE 3

| TEMPERATURE | REACTION COMPLETION TIME | % Wt. GAIN |
|---|---|---|
| (°C) | (h) | (Al Basis) |
| 1100 | 1.7 | 51.9 |

**EXAMPLE 5**

A 150 g ingot of Al-2.5 wt.% Sr alloy was placed into a high purity alumina crucible and heated to 1200°C over 1 hour under 6 L/min of flowing nitrogen. The nitrogen inlet and exit flows were measured and the nitrogen consumption monitored. The nitrogen consumption data indicated that the reaction was complete after approximately 1.5 hours after the beginning of the experiment. Unfortunately, the weight gain could not be determined due to spillage, but visual observation coupled with the nitrogen consumption data indicated that the reaction appeared to be complete.

**EXAMPLE 6**

9

In this Example, AlN was synthesized from various doped aluminum starting materials. The products were then sintered either with or without sintering aids in a flowing atmosphere of nitrogen gas and the densities and thermal conductivities of the sintered shapes were measured. The thermal conductivity values were derived from thermal diffusivities of the AlN shapes, measured by the Laser Flash method. The latter involved uniform pulse heating of the front surfaces of disk shaped sintered AlN shapes with a $CO_2$ laser pulse, and measuring the resulting temperature transient of the rear surface. The results are known to be accurate within the range of ±1%.

The results are shown in Table 4 below.

## TABLE 4

| SINTERED SHAPE ID | METHOD OF PREP. OF AlN | SINTERING ADDITIVE | SINTERING TEMPERATURE (°C)/ DURATION (h) | SINTERED DENSITY (g/cm$^3$) | THERMAL COND. OF SINTERED SHAPE (W/m.K) |
|---|---|---|---|---|---|
| 5993-27-5 | Nitridation of an alloy of high purity Al/1 w% Sr at 1100°C over 12 h. | 3 w% Y$_2$O$_3$ | 1950/5 | 3.122 | 165 |
| 5958-99-1 | Nitridation of an alloy of commercial purity Al/0.5 w% Ca at 1100°C over 12 h | None | 1950/5 | 3.065 | 103 |
| 5958-99-2 | Nitridation of an alloy of commercial purity Al/0.5 w% Ca at 1100°C over 12 h. | 3 w% Y$_2$O$_3$ | 1950/5 | 3.100 | 140 |
| 5958-99-3 | Nitridation of an alloy of commercial purity Al/0.5 w% Ca at 1100°C over 12 h. | 30 w% fine AlN powder, 3 w% Y$_2$O$_3$ | 1950/5 | 3.193 | 164 |
| 5958-38-3 | Nitridation of an alloy of commercial purity Al/1.5 w% Sr at 1100°C over 12 h | None | 1950/3 | 3.15 | – |
| 5958-81-4 | Nitridation of an alloy of high purity Al/1 w% Sr at 1100°C over 12 h. | 3 w% Y$_2$O$_3$ | 1850/5 | 3.20 | 135 |
| 5958-84-4 | Nitridation of an alloy of high purity Al/1 w% Sr at 1100°C over 12 h | 3 w% Y$_2$O$_3$ | 1850/7 | 3.20 | 135 |
| 5958-81-5 | Nitridation of an alloy of high purity Al/3 w% Mg at 1200°C. The AlN product was purified to remove residual Mg | 3 w% Y$_2$O$_3$ | 1850/5 | 3.17 | 4.7 |

## TABLE 4 (continued)

| SINTERED SHAPE ID | METHOD OF PREP. OF AlN | SINTERING ADDITIVE | SINTERING TEMPERATURE (°C)/ DURATION (h) | SINTERED DENSITY (g/cm$^3$) | THERMAL COND. OF SINTERED SHAPE (W/m.K) |
|---|---|---|---|---|---|
| 5958-84-5 | Nitridation of an alloy of high purity Al/3 w% Mg at 1200°C. The AlN product was purified to remove residual Mg | 3 w% Y$_2$O$_3$ | 1850/7 | 3.16 | 4.5 |
| 5958-84-2 | Nitridation of an alloy of high purity Al/3 w% Mg at 1200°C. The AlN product was purified to remove residual Mg | 30 w% fine AlN powder, 3 w% Y$_2$O$_3$ | 1850/5 | 3.01 | 127 |
| 6221-7-1 | Nitridation of an alloy of high purity Al/1 w% Mg at 1200°C over 10.5 h. | 3 w% Y$_2$O$_3$ | 1900/6 | 3.28 | 35 |
| 6221-8-1 | Nitridation of an alloy of high purity Al/2.5 w% Sr at 1200°C over 2 h. | None | 1900/4 | 3.26 | 90 |
| 6221-8-4 | Nitridation of an alloy of high purity Al/2.5 w% Sr at 1200°C over 2 h | 3 w% Y$_2$O$_3$ | 1900/4 | 3.26 | 153 |
| 6221-9-1 | Nitridation of an alloy of high purity Al/4.5 w% Ca at 1200°C over 4 h. | None | 1900/4 | 3.09 | 88 |
| 6221-9-3 | Nitridation of an alloy of high purity Al/4.5 w% Ca at 1200°C over 4 h | 3 w% Y$_2$O$_3$ | 1900/4 | 3.15 | 121 |

**EXAMPLE 7**

Unreactive AlN powder was produced (lot #6196-26) from Al-Mg alloy using the process of the invention. Attempts to sinter a powder compact of this material under nitrogen at 1850°C for 3 hours yielded a pellet with a density of 2.031 g/cc. The addition of 3 wt % of $Y_2O_3$ as a sintering aid yielded a pellet with a density of 3.099 g/cc. This demonstrated the need for the use of a sintering aid with this powder.

A mixture of 70 wt % of the powder having low sinterability and 30 wt % of a commercial AlN powder having high sinterability was subjected to the same sintering conditions. The fired properties were improved by the addition of the reactive powder (see Table 4).

## Claims

1. A process for preparing aluminum nitride, which comprises: reacting molten aluminum with a reagent selected from the group consisting of nitrogen and nitrogen precursors, at a pressure of up to about 0.2 MPa (absolute), the reaction being carried out in the presence of less than 5% by weight of a dopant, based on the total weight of the aluminum and the dopant, selected from the group consisting of magnesium, calcium, strontium and barium.

2. A process according to claim 1, wherein said dopant is magnesium, preferably present in an amount of 0.1 to 3% by weight, or calcium, preferably present in an amount of 0.1 to 3% by weight, or barium, preferably present in an amount of 0.1 to 3% by weight, or strontium, preferably present in an amount of 0.1 to 3% by weight.

3. A process according to claim 1 or 2 for producing said aluminum nitride in the form of particles, which comprises subjecting aluminum nitride produced by reacting said molten aluminum with said reagent to comminution.

4. A process according to claim 1 or 2, wherein said dopant is alloyed with said aluminum prior to the reaction of the molten aluminum with said reagent.

5. A process according to claim 1 or 2, wherein said dopant is present at a surface of the molten aluminum during the reaction of the molten aluminum with said reagent.

6. A process according to claim 1 or 2, wherein the dopant is generated from a dopant precursor immediately prior to the reaction of the molten aluminum with said reagent.

7. A process according to any one of the preceding claims, wherein the reaction is carried out at a temperature below about 1750° C, preferably in the range of about 550-1650° C, and more preferably in the range of about 800-1450° C.

8. A process according to any one of the preceding claims, wherein said reagent is selected from the group consisting of diatomic nitrogen, monatomic nitrogen, ionic nitrogen and nitrogen derived from a precursor material.

9. A process according to any one of the preceding claims, wherein the reaction is carried out for a period of time of up to 24 hours.

10. A process according to any one of the preceding claims, wherein the aluminum nitride product is subjected to an additional heating step in a controlled atmosphere, in order to remove any remaining dopant or nitride thereof contaminating the aluminum nitride product, said additional heating step preferably being carried out at a pressure in the range of $1.33 \times 10^{-4}$ Pa to 0.2 MPa (absolute) and at a temperature of about 550-1650° C.

11. A process according to any one of the preceding claims, wherein said reaction is carried out in conditions which result in the formation of aluminum nitride crystals in the size range of 1μm-10μm, the crystals preferably having a shape selected from the group consisting of equiaxial, plate-like, dendritic and acicular.

12. Aluminum nitride in the form of single crystal particles having a size in the range of 1μm-10μm, preferably either in the form of accicular particles having a size of about 1μm x 10μm, or in the form of substantially equiaxial particles having a size of 1μm-2μm, or in the form of platelets having a size of 1μm-2μm x 4μm-5μm, or in the form of dendritic particles.

13. Aluminum nitride according to claim 12, when produced by a process which comprises reacting molten aluminum with a reagent selected from the group consisting of nitrogen and nitrogen precursors, at a pressure of up to about 0.2 MPa (absolute), the reaction being carried out in the presence of less than 5% by weight of a dopant, based on the total weight of the aluminum and the dopant, selected from the group consisting of magnesium, calcium, strontium and barium.

14. A method of producing a sintered body of aluminum nitride which comprises mixing a highly sinterable form of aluminum nitride particles with particles selected from the group consisting of low surface area, large grain size and unreactive forms of aluminum nitride, and heating the mixture to sintering temperatures, wherein the highly sinterable form of aluminum nitride particles is preferably mixed with aluminum nitride particles comprising single crystals having a size in the range of 1μm-10μm.

15. A method of producing a sintered body of aluminum nitride, which comprises mixing a powder of an alloy of aluminum and a dopant selected from the group consisting of magnesium, calcium, strontium and barium, with an aluminum nitride powder and heating said mixture under an atmosphere selected from the group consisting of nitrogen and nitrogen precursors at a temperature between the melting point of said alloy and the usual sintering temperature of aluminum nitride.

FIG. 1

FIG. 2

FIG. 3

FIG. 4

FIG. 5

FIG. 6